# EUROPÄISCHE PATENTSCHRIFT

(11) **EP 1 219 724 B1**
(45) Veröffentlichungstag und Bekanntmachung des Hinweises auf die Patenterteilung: **16.03.2011**
(21) Anmeldenummer: 01128949.3
(22) Anmeldetag: 06.12.2001
(51) Int. Cl.: C23C 14/08, C01G 23/04, C01F 17/00

(54) **Aufdampfmaterial zur Herstellung hochbrechender optischer Schichten**
Material for vapour deposition of high refractive optical layers
Matériau pour la deposition par vapeur des couches optiques à haute index de refraction

(30) Priorität: 29.12.2000 DE 10065647
(43) Veröffentlichungstag der Anmeldung: 03.07.2002
(73) Patentinhaber: Merck Patent GmbH, 64293 Darmstadt (DE)
(72) Erfinder: Anthes, Uwe, 64711 Erbach (DE); Friz, Martin, Dr., 64297 Darmstadt (DE)

(56) Entgegenhaltungen:
- EP-A- 1 008 868
- DE-A- 4 208 811
- CHEMICAL ABSTRACTS, vol. 89, no. 10, 4. September 1978 (1978-09-04) Columbus, Ohio, US; abstract no. 83952y, QUILL L L : "78-INORGANIC CHEMICALS AND REACTIONS" Seite 576; XP002195735 -& BAZUEV ET AL : "SYNTHESIS AND X-RAY DIFFRACTION STUDIES OF PHASES OF VARIABLE COMPOSITION LN2/3TIO3+Y WITH PEROVSKITE STRUCTURE" ZH. NEORG. KHIM., Bd. 23, Nr. 6, 1978, Seiten 1451-1455, XP008002423 USSR

## Beschreibung

Die Erfindung betrifft ein Aufdampfmaterial zur Herstellung hochbrechender optischer Schichten aus Titanoxid, Titan und Lanthanoxid im Vakuum und ein Verfahren zur Herstellung des Aufdampfmaterials.

Oxidschichten werden in der Technik, insbesondere in der Optik in großem Umfang als Schutzschichten oder für optische Funktionszwecke verwendet. Sie dienen als Schutz gegen Korrosion und mechanische Beschädigung oder zur Vergütung der Oberflächen optischer Bauteile und Instrumente, wie Linsen, Spiegel, Prismen, Objektive und dergleichen. Weiterhin werden die Oxidschichten zur Herstellung hoch-, mittel- und niedrigbrechender optischer Schichten zur Reflexionserhöhung oder -erniedrigung eingesetzt. Die wichtigsten Anwendungsgebiete sind die Herstellung von Antireflex- und Vergütungsschichten auf Brillengläsern sowie auf Linsen für Kameraobjektive, für Ferngläser und optische Bauteile für optische Bauelemente und für die Lasertechnik. Weitere Anwendungen sind die Herstellung von Schichten mit bestimmtem Brechungsindex und/oder bestimmten optischen Absorptionseigenschaften, beispielsweise für Interferrenzspiegel, Strahlenteiler, Wärmefiltern und Kaltlichtspiegeln.

Aus der DE 42 08 811 A1 ist ein Aufdampfmaterial zur Herstellung hochbrechender optischer Schichten durch Bedampfen von Substraten im Vakuum bekannt. Bei dem Material handelt es sich um eine Verbindung der Form La₂Ti₂O₇₋ₓ mit x = 0,3 bis 0,7. Insbesondere handelt es sich um eine Verbindung der Formel La₂Ti₂O_{6,5}. Solche Aufdampfmaterialien werden in der Weise hergestellt, dass Oxide von Lanthan und Titan sowie metallisches Titan im entsprechenden stöchiometrischen Verhältnis gemischt und im Hochvakuum unterhalb der Schmelztemperatur gesintert werden.

Aus der DE-PS 1 228 489 ist ein Verfahren zum Herstellen dünner, im sichtbaren Wellenlängenbereich praktisch absorptionsfreien Oxidschichten für optische Zwecke insbesondere auf Unterlagen aus Glas, durch Aufdampfen oxidischer und/oder oxidierbarer Substanzen im Vakuum bekannt. Das Aufdampfen kann gegebenenfalls in Gegenwart einer oxidierenden Atmosphäre stattfinden. Mit den oxidischen und/oder oxidierbaren Substanzen werden ein oder mehrere Elemente und/oder Oxide aus der Gruppe der Seltenen Erden, einschließlich Yttrium, Lanthan und Cer aufgedampft. Dabei werden die Ausgangssubstanzen als Gemisch verdampft bzw. getrennt voneinander verdampft. Als oxidische und/oder oxidierbare Substanzen werden unter anderem Titan und/oder Titanoxid verwendet.

Für die Herstellung von hochbrechenden Schichten, die einen optischen Brechungsindex um den Wert 2 aufweisen, ist die Auswahl an geeigneten Ausgangsstoffen begrenzt. Als Ausgangsmaterialen hierfür kommen im wesentlichen die Oxide von Titan, Zirkon, Hafnium und Tantal sowie Mischsysteme hiervon in Betracht. Ein bevorzugtes Ausgangsmaterial für hochbrechende Schichten ist Titandioxid.

Im Stand der Technik kommen des weiteren neben Titanoxid Verbindungen wie Tantaloxid, Zirkonoxid, Hafniumoxid und Zinksulfid und Mischungen aus Oxiden beispielsweise Zirkonoxid und Titanoxid, Titanoxid und Praseodymoxid und Titanoxid und Lanthanoxid zur Anwendung.

Von Vorteil ist bei diesen Substanzen, dass beispielsweise Titandioxid einen hohen Brechungsindex besitzt, und Hafnium- und Zirkondioxid geringe Absorption aufweisen. Nachteile dieser bekannten Substanzen sind starkes Ausgasen und Spritzen der Titandioxide, relativ hohe Absorption bei Tantaloxid Ta₂O₅, bei einer Mischung aus Titanoxid und Praseodymoxid sowie unvollständiges Einschmelzen von Zirkonoxid, Hafniumdioxid und einer Mischung aus Zirkonoxid und Titanoxid, aber auch geringe Härte wie beispielsweise bei Zinksulfid. Bei einer Mischung aus Titanoxid und Lanthanoxid werden die Vorteile einer geringen Absorption, kein Ausgasen und kein Spritzen sowie relativ gutes Einschmelzen erzielt. Jedoch ist der Brechungsindex ein derartigen Mischung deutlich niedriger als bei Titandioxid und Zinksulfid. In verarbeitungspraktischer Hinsicht ist auch von Nachteil, dass diese Substanzen hohe Schmelz- und Siedepunkte haben, die außerdem relativ nahe beieinander liegen. Um eine gleichmäßige und ausreichende Abdampfrate zu gewährleisten, ist es erforderlich, dass die Aufdampfmaterialien vor dem Beginn einer merklichen Abdampfung vollständig eingeschmolzen sind. Diese Bedingung ist notwendig, damit sich auf den zu bedampfenden Objekten homogene und gleichmäßig dicke Schichten ausbilden können. Bei den Oxiden von Zirkon und Hafnium sowie bei Titan-Zirkon-Mischoxidsystemen ist dies aber unter praktischen Anwendungsbedingungen nicht der Fall. Diese genannten Substanzen schmelzen unter den typischen Arbeitsbedingungen nicht bzw. nicht vollständig ein, sie sind insgesamt schwierig zu verdampfen und es ergeben sich Dickenschwankungen in den aufgedampften Schichten. Im Stand der Technik geht das Bestreben dahin, durch geeignete Zusätze die Schmelzpunkte der Grundmaterialien herabzusetzen, wobei diese Zusätze weiterhin dazu dienen, den Brechungsindex in den erhaltenen Schichten in bestimmten Grenzen zu variieren und gezielt einzustellen. Die Auswahl an geeigneten Zusätzen für diese Zwecke ist durch die Forderung nach Absorptionsfreiheit eingeschränkt. Es kommen daher nur solche Metalloxide als entsprechende Zusätze in Frage, die im sichtbaren Spektralbereich bis in nahem UV-Wellenlängenbereich, das ist bis ca. 320 nm, keine Absorptionen aufweisen.

Als Ausgangsmaterial haben die genannten Oxide keine oder nur geringe Absorptionen im sichtbaren Wellenlängenbereich, was Grundvoraussetzung für entsprechende optische Anwendungen ist. Jedoch kommt es bei der Hochvakuumverdampfung zu einem Verlust von Sauerstoff und der Abscheidung von in Bezug auf den Sauerstoffanteil unterstöchiometrischen Titanoxidschichten. Dies bedeutet, dass ohne eine spezielle Vorsichtsmaßnahme die Herstellung dünner Schichten durch Vakuumverdampfung mit diesen Materialien zu Schichten mit hoher Absorption im sichtbaren Bereich führt. Gemäß der zuvor genannten DE-PS 1 228 489 wird dieses Problem in der Weise gelöst, dass die Verdampfung in einem Vakuum mit einem gewissen Sauerstoff-Restdruck von 5 * 10 ⁻⁵ bis < 5 * 10 ⁻⁴ mbar erfolgt, das heißt eine oxidierende Atmosphäre eingestellt wird. Eine andere Möglichkeit zur Lösung dieses Problems besteht darin, die erhaltenen Schichten einer Nachtemperung in Sauerstoff oder Luft zu unterziehen.

Auch wenn durch geeignete Wahl an Zusatzstoffen bzw. die Auswahl entsprechender Stoffgemische die vorgenannten Probleme gelöst werden können, ist der Einsatz von Mischsystemen an sich in der Vakuum-Aufdampftechnik nicht zu bevorzugen. Der Grund liegt darin, dass Mischsysteme in der Regel inkongruent verdampfen, d.h. sie verändern im Verlaufe des Verdampfungsprozesses ihre Zusammensetzung und entsprechend verändert sich auch die Zusammensetzung der abgeschiedenen Schichten. Dies läßt sich dadurch vermeiden, dass die Mischsysteme aus diskreten chemischen Verbindungen bestehen, die ohne stoffliche Veränderung verdampfen und wieder kondensieren.

Aufgabe der Erfindung ist es, ein Aufdampfmaterial der eingangs beschriebenen Art bereitzustellen, aus dem optische Schichten mit einem möglichst hohen Brechungsindex und geringer Absorption herstellbar sind, wobei das Aufdampfmaterial ein sehr gutes Einschmelz- und Verdampfungsverhalten zeigt und praktisch ohne Ausgasen und Spritzen verdampft werden kann.

Diese Aufgabe wird erfindungsgemäß in der Weise gelöst, dass es sich um ein gesintertes Gemisch aus 58,9 Gew.-% Lanthanoxid, 37,9 Gew.-% Titandioxid und 3,2 Gew.-% Titan bezogen auf das Gesamtgewicht des Gemisches, handelt.

In Ausgestaltung der Erfindung legt das Verhältnis Titandioxid TiO₂ zu Titan die Stöchiometrie in Bezug auf den Sauerstoff im Titanoxid TiOₓ für x = 1,75 fest. Dabei ist das Gewichtsverhältnis Titan- zu Lanthanoxid durch Zumischen von Lanthanoxid zu dem Gemisch aus Titandioxid und Titan bestimmbar. Durch Sintern im Vakuum wird gewährleistet, dass die Stöchiometrie der Mischung in Bezug auf den Sauerstoff sich nicht ändert. Das erfindungsgemäße Aufdampfmaterial weist gegenüber der stöchiometrisch exakt zusammengesetzten Basisverbindung Lanthantitanat einen im Rahmen der voranstehend angeführten Formeldefinition liegenden Sauerstoffunterschuss auf. Durch die gezielte Einstellung des Sauerstoffunterschusses in dem erfindungsgemäßen Aufdampfmaterial tritt einerseits während der Vakuumverdampfung keine weitere Abgabe von Sauerstoff auf, die zu dem unerwünschten Spritzen der erschmolzenen Aufdampfmaterialien führt. Andererseits liegt der gewählte Bereich des Sauerstoffunterschusses so, dass sich unter den üblichen Arbeitsbedingungen bei der Vakuumverdampfungstechnik noch ohne weiteres absorptionsfreie Schichten bilden. Untersuchungen haben gezeigt, dass schon durch einen relativ geringen Zusatz an Lanthanoxid das Verhalten beim Einschmelzen und Verdampfen verbessert werden kann. Die erfindungsgemäße Mischung kann durch Einstellen einer optimalen Stöchiometrie in Bezug auf Sauerstoff praktisch ohne Spritzen und ohne Ausgasen in einer Elektronenstrahlverdampfereinrichtung eingeschmolzen und verdampft werden. Hierbei zeigt sich, dass die optischen Eigenschaften der erhaltenen Schichten kaum durch Schwankungen des Sauerstoffrestdruckes während der Vakuumverdampfung beeinflußt werden. Im Vergleich hierzu ist bei Titan(IV)-oxid TiO₂ und auch bei Titansuboxiden wie TiO_{1,7}, Ti₃O₅ oder Ti₄O₇ Spritzen beim Einschmelzen nicht völlig zu vermeiden. Der Brechungsindex von Schichten, die mit dem erfindungsgemäßen Aufdampfmaterial hergestellt werden, ist nur wenig niedriger als bei reinen Titanoxidschichten. Insbesondere ist der Brechungsindex wesentlich höher als bei Schichten aus Tantaloxid, Zirkonoxid, Hafniumoxid oder aus Mischungen aus Oxiden wie Zirkonoxid und Titanoxid, Titanoxid und Praseodymoxid und Titanoxid und Lanthanoxid. Durch das gute Einschmelzverhalten ist es möglich für das Verdampfen des Aufdampfmaterials eine ebene Schmelzoberfläche einzustellen und aufrechtzuerhalten. Dadurch kann dann eine gleichmäßige, reproduzierbare Schichtdickenverteilung auf den zu beschichtenden Substraten eingestellt werden. Dies ist insbesondere beim Einsatz von Materialien, die schlechter einschmelzen wie beispielsweise Hafniumoxid, Zirkonoxid, einer Mischung aus Zirkonoxid und Titanoxid sehr schwierig, wenn überhaupt realisierbar.

Im Rahmen der Aufgabe der Erfindung soll des weiteren ein Verfahren bereitgestellt werden, das es ermöglicht Aufdampfmaterialien herzustellen, die ohne Spritzen und Ausgasen zu optischen Schichten mit hohem Brechungsindex verarbeitet werden können. Dies geschieht in der Weise, dass ein Gemisch aus Titandioxid, Titan und Lanthanoxid mit der Zusammensetzung 58,9 Gew.-% Lanthanoxid, 37,9 Gew.-% Titandioxid und 3,2 Gew.-% Titan, bezogen auf das Gesamtgewicht des Gemisches, homogen gemischt, auf eine Korngröße von 1 bis 4 mm granuliert oder tablettiert und anschließend im Vakuum gesintert wird. In Ausführung des Verfahrens wird in einem Vakuum von 1 x 10⁻⁴ mbar bei einer Temperatur von 1500 bis 1600 °C über eine Zeitdauer von 5 ½ bis 6 ½ Stunden gesintert.

Ferner soll ein Verfahren bereitgestellt werden, das es ermöglicht, aus den Aufdampfmaterialien optische Schichten mit hohem Brechungsindex und weitgehender Absorptionsfreiheit herzustellen. Dies geschieht in der Weise, dass zu beschichtende Substrate gereinigt, getrocknet, auf einer Substrathaltevorrichtung in einer Aufdampfanlage befestigt werden, dass die Aufdampfanlage auf 1 x 10⁻⁵ mbar evakuiert, die Substrate auf 280 bis 310 °C aufgeheizt werden, dass Sauerstoff in die Aufdampfanlage bis zum Erreichen eines Druckes von 1 bis 2 x 10⁻⁴ mbar eingelassen wird, dass das Aufdampfmaterial in einer durch eine Blende abgeschlossenen Elektronenstrahlverdampfereinrichtung der Aufdampfanlage eingeschmolzen und auf seine Verdampfungstemperatur vom 2200 bis 2300 °C erhitzt wird und dass nach Öffnen der Blende die Substrate bis zu einer vorgegebenen Dicke mit dem Aufdampfmaterial beschichtet werden. Es werden dabei optische Schichten aus dem Aufdampfmaterial mit einem Brechungsindex von 2,15 bis 2,25, insbesondere von 2,20 für eine Wellenlänge von 500 nm erhalten. Derartige optische Schichten finden weite Verbreitung und Verwendung als Antireflex- und Vergütungsschichten auf Brillengläsern, Linsen für optische Instrumente, optische Bauteile für die Lasertechnik sowie als Schichten mit vorgegebenem hohem Brechungsindex und/oder optischen Absorptionseigenschaften für Strahlenteiler, Interferenzspiegel, Kaltlichtspiegel und Wärmeschutzfilter.

Mit dem Aufdampfmaterial nach der Erfindung können auf geeigneten Substraten homogene dünne Schichten gleichmäßiger Schichtdicke erzeugt werden, die haftfest und in besonderem Maße gegen mechanische und chemische Einflüsse resistent sind. Wie schon erwähnt, sind diese Schichten hochbrechend, und haben im allgemeinen eine hohe Transmission in einem Wellenlängenbereich von nahe UV, das ist etwa bei einer Wellenlänge von 360 nm über den sichtbaren Bereich bis in das nahe Infrarot bei einer Wellenlänge von ca. 7000 nm. Im sichtbaren Wellenlängenbereich sind diese optischen Schichten weitgehend frei von Absorption.

Die Erfindung wird im Folgenden anhand einesBeispiels näher erläutert.

### Beispiel 1

Ein Gemisch aus 58,9 Gew.-% Lanthanoxid, 37,9 Gew.-% Titandioxid und 3,2 Gew.-% Titan wird homogen gemischt, auf eine Korngröße von etwa 1 - 4 mm granuliert und im Vakuum bei etwa 1500 °C 6 Stunden lang gesintert. Das gesinterte Produkt ist tiefschwarz.

Zur Herstellung von optischen Schichten wird das gesinterte Produkt in einen Molybdän-Tiegel einer Aufdampfanlage gefüllt und in die Elektronenstrahlverdampfereinrichtung der Anlage eingesetzt. Die zu beschichtenden Substrate wie beispielsweise Scheiben aus Quarzglas mit einem Durchmesser von 25 mm und einer Dicke von 1mm werden gereinigt und getrocknet und auf einer Substrathaltevorrichtung in der Aufdampfanlage befestigt. Bei der Aufdampfanlage handelt es sich um eine im Stand der Technik bekannte Anlage, die weder zeichnerisch dargestellt noch im Einzelnen beschrieben wird. Nach Evakuieren auf einen Druck von 1 x 10⁻⁵ mbar werden die Substrate auf eine Temperatur von etwa 300 °C aufgeheizt. Dann wird über ein Regulierventil Sauerstoff in die Aufdampfanlage bis zum Erreichen eines Drucks von 1 bis 2 x 10⁻⁴ mbar eingelassen. Das Aufdampfmaterial wird unter einer Blende der Elektronenstrahlverdampfereinrichtung aufgeschmolzen und auf die Verdampfungstemperatur von 2200 °C erhitzt. Sobald diese Verdampfungstemperatur erreicht ist, wird die Blende geöffnet und die Substrate mit einer optischen Schicht der gewünschten Dicke beschichtet. Nach dem Abkühlen werden die beschichteten Substrate der Aufdampfanlage entnommen. Mit einem Spektralfotometer wurde die Transmission der Schichten bestimmt. Aus dem Transmissionsverlauf wurde der Brechungsindex von 2,20 bei einer Wellenlänge von 500 nm ermittelt. Die Schichtdicke betrug 267 nm.

## Patentansprüche

1. Aufdampfmaterial zur Herstellung hochbrechender optischer Schichten aus Titandioxid, Titan und Lanthanoxid im Vakuum, **dadurch gekennzeichnet, dass** es sich um ein gesintertes Gemisch aus 58,9 Gew.-% Lanthanoxid, 37,9 Gew.-% Titandioxid und 3,2 Gew.-%Titan bezogen auf das Gesamtgewicht des Gemisches handelt.

2. Aufdampfmaterial nach Anspruch 1, **dadurch gekennzeichnet, dass** das Gemisch Partikel mit einer Korngröße von 1 bis 4 mm enthält.

3. Verfahren zur Herstellung eines Aufdampfmaterials nach den Ansprüchen 1 bis 2, **dadurch gekennzeichnet, dass** ein Gemisch aus Titandioxid, Titan und Lanthanoxid mit der Zusammensetzung aus 58,9 Gew.-% Lanthanoxid, 37,9 Gew.-% Titandioxid und 3,2 Gew.-% Titan, bezogen auf das Gesamtgewicht des Gemisches, homogen gemischt, auf eine Korngröße von 1 bis 4 mm granuliert oder tablettiert und anschließend in Vakuum gesintert wird.

4. Verfahren nach Anspruch 3, **dadurch gekennzeichnet, dass** in einem Vakuum von 10⁻⁴ mbar bei einer Temperatur von 1500 bis 1600 °C über eine Zeitdauer von 5,5 bis 6,5 Stunden gesintert wird.

5. Verfahren zur Herstellung von optischen Schichten aus dem Aufdampfmaterial nach den Ansprüchen 1 bis 2, **dadurch gekennzeichnet, dass** die zu beschichtenden Substrate gereinigt, getrocknet und auf einer Substrathaltevorrichtung in einer Aufdampfanlage befestigt werden, dass die Aufdampfanlage auf 1 x 10⁻⁵ mbar evakuiert, die Substrate auf 280 bis 310 °C aufgeheizt werden, dass Sauerstoff in die Aufdampfanlage bis zum Erreichen eines Druckes von 1 bis 2 x 10⁻⁴ mbar eingelassen wird, dass das Aufdampfmaterial in einer durch eine Blende abgeschlossenen Elektonenstrahlverdampfereinrichtung der Aufdampfanlage eingeschmolzen und auf seine Verdampfungstemperatur von etwa 2200 bis 2300 °C erhitzt wird und dass nach Öffnen der Blende die Substrate bis zu einer vorgegebenen Dicke mit dem Aufdampfmaterial beschichtet werden.

6. Verwendung der gemäß Anspruch 5 hergestellten optischen Schichten als Antireflex- und Vergütungsschichten auf Brillengläsern, Linsen für optische Instrument, optische Bauteile für die Lasertechnik sowie als Schichten mit vorgegebenem hohem Brechungsindex und/oder optischen Absorptionseigenschaften für Strahlenteiler, Interferrenzspiegel, Kaltlichtspiegel und Wärmeschutzfilter.

## Claims

1. Vapour-deposition material for the production of high-refractive-index optical layers of titanium dioxide, titanium and lanthanum oxide in vacuo, **characterised in that** it is a sintered mixture comprising 58.9% by weight of lanthanum oxide, 37.9% by weight of titanium dioxide and 3.2% by weight of titanium, based on the total weight of the mixture.

2. Vapour-deposition material according to Claim 1, **characterised in that** the mixture comprises particles having a particle size of 1 to 4 mm.

3. Process for the preparation of a vapour-deposition material according to Claims 1 to 2, **characterised in that** a mixture of titanium dioxide, titanium and lanthanum oxide having the composition 58.9% by weight of lanthanum oxide, 37.9% by weight of titanium dioxide and 3.2% by weight of titanium, based on the total weight of the mixture, is mixed homogeneously, granulated or tabletted to a particle size of 1 to 4 mm, and subsequently sintered in vacuo.

4. Process according to Claim 3, **characterised in that** the sintering is carried out in a vacuum of 10⁻⁴ mbar at a temperature of 1500 to 1600°C over a period of 5.5 to 6.5 hours.

5. Process for the production of optical layers of the vapour-deposition material according to Claims 1 to 2, **characterised in that** the substrates to be coated are cleaned, dried and mounted on a substrate holder in a vapour-deposition unit, the vapour-deposition unit is evacuated to 1 x 10⁻⁵ mbar, the substrates are heated to 280 to 310°C, oxygen is admitted into the vapour-deposition unit until a pressure of 1 to 2 x 10⁻⁴ mbar has been reached, the vapour-deposition material is melted in an electron-beam evaporator, sealed off by a screen, in the vapour-deposition unit and heated to its evaporation temperature of about 2200 to 2300°C, and, after the screen has been opened, the substrates are coated with the vapour-deposition material to a predetermined thickness.

6. Use of the optical layers produced in accordance with Claim 5 as antireflection layers on spectacle lenses, lenses for optical instruments, optical components for laser technology and as layers having a pre-specified high refractive index and/or optical absorption properties for beam splitters, interference mirrors, cold-light mirrors and heat-protection filters.

## Revendications

1. Matériau de dépôt en phase vapeur pour la production de couches optiques à indice de réfraction élevé en dioxyde de titane, en titane et en oxyde de lanthane sous vide, **caractérisé en ce qu'**il s'agit d'un mélange fritté comprenant 58,9% en poids d'oxyde de lanthane, 37,9% en poids de dioxyde de titane et 3,2% en poids de titane, sur la base du poids total du mélange.

2. Matériau de dépôt en phase vapeur selon la revendication 1, **caractérisé en ce que** le mélange comprend des particules présentant une taille de particule de 1 à 4 mm.

3. Procédé pour la préparation d'un matériau de dépôt en phase vapeur selon les revendications 1 à 2, **caractérisé en ce qu'**un mélange de dioxyde de titane, de titane et d'oxyde de lanthane présentant la composition constituée par 58,9% en poids d'oxyde de lanthane, 37,9% en poids de dioxyde de titane et 3,2% en poids de titane, sur la base du poids total du mélange, est mélangé de façon homogène, est conformé en granulat ou en comprimés selon une taille de particule de 1 à 4 mm, et est ensuite fritté sous vide.

4. Procédé selon la revendication 3, **caractérisé en ce que** le frittage est mis en oeuvre sous un vide de 10⁻⁴ mbar à une température de 1500 à 1600°C pendant une période de 5,5 à 6,5 heures.

5. Procédé pour la production de couches optiques du matériau de dépôt en phase vapeur selon les revendications 1 à 2, **caractérisé en ce que** les substrats destinés à être revêtus sont nettoyés, séchés et montés sur un support de substrat dans une unité de dépôt en phase vapeur, l'unité de dépôt en phase vapeur est mise sous vide à 1 x 10⁻⁵ mbar, les substrats sont chauffés à 280 à 310°C, de l'oxygène est admis à l'intérieur de l'unité de dépôt en phase vapeur jusqu'à ce qu'une pression de 1 à 2 x 10⁻⁴ mbar soit atteinte, le matériau de dépôt en phase vapeur est fondu dans un évaporateur à faisceau d'électrons, confiné par un écran, dans l'unité de dépôt en phase vapeur et est chauffé jusqu'à sa température d'évaporation d'environ 2200 à 2300°C, et, après que l'écran a été ouvert, les substrats sont revêtus du matériau de dépôt en phase vapeur selon une épaisseur prédéterminée.

6. Utilisation des couches optiques produites selon la revendication 5 en tant que couches antireflet sur des lentilles de lunettes, des lentilles pour des instruments optiques, des composants optiques pour technologie laser et en tant que couches présentant un indice de réfraction élevé préspécifié et/ou des propriétés d'absorption optique pour des séparateurs de faisceau, des miroirs d'interférence, des miroirs de lumière froide et des filtres de protection thermique.
